(19) Europäisches Patentamt
European Patent Office
Office européen des brevets

(11) EP 0 553 208 B1

(12) EUROPEAN PATENT SPECIFICATION

(45) Date of publication and mention of the grant of the patent: **07.08.1996 Bulletin 1996/32**

(21) Application number: **91919046.2**

(22) Date of filing: **17.10.1991**

(51) Int Cl.[6]: **C11D 7/50**, C23G 5/024, C23G 5/06

(86) International application number: **PCT/EP91/01987**

(87) International publication number: **WO 92/07058 (30.04.1992 Gazette 1992/10)**

# (54) METHOD AND COMPOSITION FOR CLEANING ARTICLES

VERFAHREN UND ZUSAMMENSETZUNG ZUM REINIGEN VON GEGENSTÄNDEN

PROCEDE ET COMPOSITION DE NETTOYAGE D'ARTICLES

(84) Designated Contracting States:
**AT BE CH DE DK ES FR GB GR IT LI LU NL SE**

(30) Priority: **17.10.1990 US 600372**

(43) Date of publication of application: **04.08.1993 Bulletin 1993/31**

(73) Proprietor: **BUSH BOAKE ALLEN Limited
London E17 5QP (GB)**

(72) Inventors:
- **FERBER, Gerald J.
Northwich, Cheshire CW8 2YH (GB)**
- **SMITH, Graham J.
Chester, Cheshire CH3 5LS (GB)**

(74) Representative: **Hildyard, Edward Martin et al
Frank B. Dehn & Co.
Imperial House
15-19 Kingsway
London WC2B 6UZ (GB)**

(56) References cited:
**EP-A- 0 164 467**
**EP-A- 0 412 475**
**NL-A- 7 113 138**
**US-A- 3 951 682**
**US-A- 4 090 562**
**US-A- 4 710 232**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).



Printed by Jouve, 75001 PARIS (FR)

## Description

## BACKGROUND OF THE INVENTION

This invention relates to a method and composition for the cleaning of dirty articles. Such articles may be, for instance, relatively small metal, ceramic or glass articles, for instance, circuit boards or machined parts.

It is routine practice to clean dirty surfaces by contacting them with an aqueous or non-aqueous liquid, and to promote the cleaning by forcing the liquid against the surfaces. Surfaces can be cleaned by water, often brushed on or applied as a jet, and then left to dry. However, water is not very effective for removing organic residues, and steaming is sometimes used.

Aqueous detergent compositions will remove organic residues, but typically leave residues of detergents, necessitating thorough rinsing to remove these residues.

The most effective way of removing organic dirt from articles is generally recognized as involving contacting the articles with organic solvents that will dissolve the residues. This method typically requires large capital investment in equipment to clean the articles by contacting the articles with an organic solvent while the articles are held within a vessel. The contact can be by immersing the articles in a liquid phase solvent or by exposing the articles to a vapor phase solvent, generally at a relatively cool temperature so that the solvent will condense on the articles.

The selected solvent must have adequate solvency power for the residues that are to be removed, it must have a flash point sufficiently -above the temperature of use that it is safe to use, and preferably have a volatility such that it does not leave a residual film of solvent on the article. Preferably, therefore, the solvent evaporates relatively quickly when exposed to the ambient atmospheric temperature of, for instance, 30°C or below.

Most low boiling hydrocarbons often have adequate solvency power and have adequate volatility, but they suffer from the disadvantage that they have low flash point. Higher boiling hydrocarbons may have adequate solvency power and a reasonably safe flash point, but their volatility is sufficiently low that residues remain on the articles unless the articles are deliberately heated, and this is undesirable because of the risk of the temperature approaching or exceeding the flash point.

Because of these difficulties, halogenated solvents were widely accepted as cleaners having suitable solvency power, adequately high flash point, and suitable volatility at safe temperatures. Examples are chlorocarbons, fluorocarbons and chlorofluorocarbons, the compounds generally containing below 4 carbon atoms, often 1 or 2 carbon atoms.

The industry has made vast investment in apparatus for cleaning hard surfaces such as circuit boards and soft surfaces such as fabrics with such solvents. Possible environmental disadvantages of the use of such solventsare widely recognized. A very large number of alternative solvents have therefore been investigated, especially in recent years, but none of them have yet proved to be commercially as convenient to use as the halogenated hydrocarbons which they are intended to replace.

There is therefore an acute need for achieving satisfactory cleaning of articles using a solvent having good solvency power which is preferably not a volatile halogenated hydrocarbon in such a way that there are substantially no solvent residues left on the article and workers are not exposed to a flash hazard. Preferably this objective would be achieved with a minimum of modification of the existing apparatus designed for use with, for instance, chlorofluorocarbons.

Among the solvents that have been investigated heretofore are terpene solvents. Such solvents have been known for a very long time. For instance, terpene-based solvents were commercially available in the early 1940's. However, they have never proved to be of widespread commercial value. Part of the problem was that they tended to contaminate the article with residues of the terpene solvent, and this contamination rendered the article unacceptable. Also, the terpenes tend to readily contaminate or to form resinous products which are difficult to remove.

NL-A-7 113 138 describes rubber cleaning compositions comprising an alcohol having an alkyl chain of up to 7 carbon atoms, trimethylbenzene, benzylic alcohol, hydroquinone and turpentine, which is an essential component thereof.

Para-menthadienes and mixtures of para-menthadienes and terpene alcohols are known as solvents ("Monocylic Terpene Hydrocarbons" and "Blended Terpene solvents," Hercules Review, 1942). However, para-menthadienes are susceptible to atmospheric oxidation (even in the presence of anti-oxidants), resulting in both formation of residue and conversion of para-menthadienes to other products (primarily para-cymene and epoxides). Oxidation and residue formation in an immersion cleaning tank will adversely affect the efficiency of the cleaning process, and cause the build-up of co-boiling impurities which reduce solvent recyclability. Hydrolytic instability resulting in residue formation in the water rinse tank also leads to contamination of the cleaned work piece.

If the hydrolytic instability is oxygen promoted, residue formation in both the rinse and immersion tanks can be significantly reduced by operating both process steps under inert gas blankets (e.g., nitrogen). However, provision of full blanketing and prevention of ingress of oxygen into the two tanks increases equipment cost and complicates the operation of the cleaning process. Furthermore, differences in boiling point of the components of the above solvent

mixture leads to different distillation rates during solvent recycle.

The object of this invention is to meet the acute need to provide a method of cleaning dirty articles, which method is environmentally acceptable and that provides articles having a cleanliness that can meet the highest standards, for instance, the standard of the electronics industry.

Additionally, the invention here is aimed at developing a solvent composition for use in the immersion-clean/steam-rinse process as described hereinunder, which does not suffer from the previously described problems.

## SUMMARY OF THE INVENTION

According to one aspect of the present invention there is provided a process for cleaning a dirty article comprising the steps of:

- contacting the dirty article with a solvent composition comprising:

  a $C_9$-$C_{12}$ aromatic hydrocarbon of formula

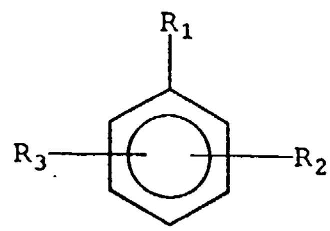

  wherein $R_1$ is $CH_3$, $R_2$ is hydrogen or a straight-chained or branched lower alkyl, and $R_3$ is hydrogen or a $C_1$-$C_5$ straight-chained alkyl; and
  a $C_7$-$C_{10}$ organic polar component,
  wherein the solvent composition comprises from about 99 to about 1 weight percent of the aromatic hydrocarbon and from about 1 to about 99 weight percent of the organic polar component;
  whereby the contact of the dirty article with the solvent composition results in a solvent residue being deposited on a surface of the article; and

- contacting the article having the solvent residue on its surface with an aqueous medium such that the solvent residue is removed by steam distillation, or forms an azeotrope with the aqueous medium and said azeotrope is removed from the surface of the article by azeotropic evaporation;
  wherein the solvent composition distils over a very narrow range, or forms an azeotrope boiling at a single temperature.

The solvent composition optionally contains a portion of water sufficient to form a water-in-oil emulsion. The solvent composition may further contain a surfactant for the purpose of assisting in forming the water-in-oil emulsion.

The invention relates not only to the above cleaning processes but also to solvent compositions *per se* comprising either only at least one said aromatic hydrocarbon and said organic polar component or in addition to these two components also water sufficient to form a water-in-oil emulsion and optionally a surfactant.

According to another aspect of the invention, there is provided the use of preferred solvent compositions for cleaning a dirty article in the process of the invention.

The aromatic hydrocarbons can be made synthetically starting from, for instance, petrochemicals, or they can also be made by dehydrogenation of certain terpenes. The polar component may be an alcohol, an amine, a ketone, or an ester which is selected such that the solvent composition distils over a very narrow range, or forms an azeotrope boiling at a single temperature.

The solvent composition is capable of cleaning a wide range of soil types from articles and exhibits improved solvent life and cleaning performance, quantitatively expressed as the soil loading capacity of the solvent, which allows the solvent to be used in cleaning a large quantity of soil.

The solvent composition is used in a cleaning process wherein a dirty article is contacted with the solvent under conditions that result in cleaning of dirt from the articles. Any residue deposited on the surface of the article is removed by contacting the contaminated article at an elevated temperature with an aqueous medium which removes the residual solvent from the article surface. The residual solvent may form an azeotrope with condensed steam in the rinse stage of the cleaning process, which azeotrope can then be removed from the article surface by evaporation.

## BRIEF DESCRIPTION OF THE DRAWINGS

Figure 1 is a graphic representation of cleaning performance comparisons in the removal of a low polarity soil, such as a light oil.

Figure 2 is a graphic representation of cleaning performance comparisons in the removal of an intermediate polarity soil, such as abietic acid.

Figure 3 is a graphic representation of soil loading capacity with respect to an intermediate soil, such as abietic acid, as a function of weight percent of a preferred polar organic component (2-ethylhexanol).

Figure 4 is a partially cut away 3-dimensional side view of an apparatus for performing cleaning and rinsing of dirty articles.

Figure 5 is a cross-sectional view of the condenser and azeotrope collection trough taken along the line 5-5 in Figure 4.

Figure 6 is a partially cut away 3-dimensional side view of a preferred apparatus for cleaning and rinsing dirty articles.

## DESCRIPTION OF THE PREFERRED EMBODIMENTS

In accordance with the present invention, it is possible to obtain articles having exceptional cleanliness, in a manner that is highly desirable from the environmental point of view. Both solvent and water used in the cleaning process can be recycled, and vapor emissions can be reduced to satisfactorily low values.

The use of solvents for cleaning articles, particularly for the removal of organic soils, is of major importance to industry. In many cleaning applications a solvent is required to remove more than one type of soil contaminant from individual articles. Different types of soil contaminants which must be removed include low polarity soils, such as oils and grease; intermediate polarity soils, such as rosin acid flux used in printed circuit board manufacture; and high polarity soils, such as inorganic ionic residues.

For a solvent to be effective in removing a wide range of soils of different polarity, it should preferably contain a mixture of non-polar and polar components. The advantage of the solvent composition of this invention is that such a wide range of soil types can be cleaned from articles. Most important is the removal of oils and grease from metal parts, and the removal of rosin fluxes and residual grease, for example, finger prints, from printed circuit boards. Accordingly, the invention provides for methods and solvent compositions for cleaning of a wide range of soils from individual articles.

According to one aspect of the present invention there is provided a solvent composition consisting only of at least one $C_9$-$C_{12}$ aromatic hydrocarbon of formula

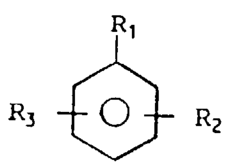

,

wherein $R_1$ is $CH_3$, $R_2$ is hydrogen or a straight-chained or branched lower alkyl, and $R_3$ is hydrogen or a $C_1$-$C_5$ straight-chained alkyl; and a $C_7$-$C_{10}$ organic polar component, wherein the solvent composition comprises from about 1 to about 99 weight percent of the organic polar component; and wherein the solvent composition distils over a very narrow range, or forms an azeotrope boiling at a single temperature. Alternative solvent compositions may contain a portion of water sufficient to form a water-in-oil emulsion, which emulsion is capable of removing high polarity soils. Where water is present in the solvent composition, a cationic, anionic, or nonionic surfactant may be used to facilitate the formation of the emulsion. The water/surfactant portion of the solvent composition, when utilized, is preferably present at levels up to about 40 weight percent.

Preferably, the solvent composition comprises from about 95 to about 5 weight percent of the aromatic hydrocarbon and from about 5 to about 95 weight percent of the organic polar component. More preferably, the solvent composition comprises from about 75 to about 25 weight percent of the aromatic hydrocarbon and from about 25 to about 75 weight percent of the polar organic component. Most preferably, the solvent composition comprises about 75 weight percent of the aromatic hydrocarbon and about 25 weight percent of the organic polar component.

The new solvent composition is superior to solvents previously used for cleaning articles in that it exhibits superior cleaning performance, is oxidative and hydrolytic stable under conditions of use, and during distillation a distillate of the solvent composition which is substantially uniform in constituency throughout distillation is recovered. The distillation procedure employed for solvent recycle can be either atmospheric or sub-atmospheric pressure distillation, or preferably steam distillation.

An important factor for commercial cleaning operations is solvent life (before recovery or disposal, as required),

which is the ability of the same solvent to be reused for cleaning a large number of dirty articles. The operational performance of the solvent will depend in part upon the number of cleaning operations which can be completed with a given solvent before fresh solvent is required. This property can be expressed quantitatively as the solvent soil loading capacity, which is expressed by the formula:

$$S = \frac{W \times C}{V \times P} \times 100$$

where W equals the average weight of soil removed from the article per cleaning cycle; C equals the last successful cleaning cycle; V equals the solvent volume; and P equals the solvent density.

Laboratory trials simulating cleaning processes have demonstrated a surprising benefit for the solvent composition disclosed which is not predictable from a knowledge of the cleaning performance of the individual aromatic hydrocarbon and polar organic components. In combining the aromatic hydrocarbon and polar organic component, a synergistic effect has been noted whereby the solvent mixture has an actual soil loading capacity which is higher than the weighted average of the soil loading capacity for the individual aromatic hydrocarbon and polar organic components. This synergistic effect provides for improved solvent life, which makes the inventive solvent composition desirable from both an economic and environmental aspect, in that less solvent will be required over a longer period of time in the cleaning process.

Another important characteristic which the solvent composition must exhibit is similar steam distillability of both components for more effective solvent removal in the steam rinse step of the disclosed process. The solvent must also possess the desired atmospheric pressure boiling points and vapor pressures for cleaning applications.

Solvents with low vapor pressures do not significantly contribute to volatile organic chemical emissions, and are easily contained within cleaning equipment without the need for specialized vapor collection or scrubbing devices. Therefore, the lower molecular weight limit for the solvent components is $C_9$ for the aromatic hydrocarbons and $C_7$ for the organic polar components. On the other hand, solvents with too high a boiling point are difficult to distill with simple equipment during solvent recovery and recycle processes. Therefore, the upper molecular weight limit for the aromatic hydrocarbon is $C_{12}$, while the upper limit for the polar organic component is $C_{10}$. Preferably, boiling points should not exceed 220°C, and ambient temperature vapor pressure should not exceed 267 Pa per 20°C.

To be used economically in a cleaning process, the solvent must be easily recycled. It is therefore essential that the solvent composition distill over a very narrow range, or form an azeotrope boiling at a single temperature. The preferred technique for solvent recycle is steam distillation in the immersion- clean/steam-rinse process. For these reasons, the aromatic hydrocarbon and polar organic component must either be capable of forming an azeotrope, or have boiling points sufficiently similar such that a distillate of the solvent composition is substantially uniform in constituency throughout recovery.

In a preferred embodiment wherein the solvent composition comprises a portion of an aromatic hydrocarbon and a portion of a polar organic component, it is demonstrated that the solvent composition efficiently cleans intermediate and low polarity soils from the articles. While the solvent composition will clean intermediate and low polarity soils, certain high polarity soils will require the concurrent use of water. Preferably, a water-in-oil emulsion would be employed through the use of a suitable surfactant. The portion of water employed will be sufficient to form a water-in-oil emulsion, which emulsion will be capable of removing the high polarity soils. The surfactant is anionic, cationic, or nonionic, and is either azeotropically volatile, or sufficiently volatile to ensure that the surfactant is removed from the article's surface along with the water-in-oil emulsion.

The solvent composition must also be stable to oxidation under the hydrolysis conditions encountered in the hot water/steam distillation during the immersion-clean/steam-rinse process. If the solvent composition does not exhibit the required stability, polymerization or degradation reactions take place, thereby forming undesired resinous or residual impurities.

The aromatic hydrocarbons utilized in the solvent composition contain from 9 to 12 carbon atoms, and are selected from the group consisting of

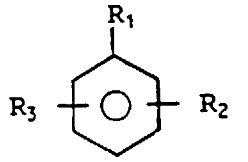 ,

or mixtures thereof, wherein $R_1$ is $CH_3$, $R_2$ is hydrogen or a straight-chained or branched lower alkyl, and $R_3$ is selected from the group consisting of hydrogen and a $C_1$-$C_5$ straight-chained alkyl. The hydrocarbons can be made synthetically starting from petrochemicals, or can be derived by dehydrogenating certain terpene compounds found in, for instance, wood and other vegetable products. More preferably, the aromatic hydrocarbon is selected from the group consisting of para-cymene, meta-cymene, trimethylbenzenes, and ethyltoluenes. Most preferably, the aromatic hydrocarbon is para-cymene.

The $C_7$-$C_{10}$ organic polar component may be an amine, alcohol, ester, or a ketone. It is selected such that it is capable of forming an azeotrope with the aromatic hydrocarbon, or has a boiling point sufficiently similar to the boiling point of the aromatic hydrocarbon such that a distillate of the solvent composition is substantially uniform in constituency throughout distillation. The organic polar component is preferably a $C_7$-$C_{10}$ alcohol; more preferably a $C_8$ saturated alcohol, such as 1-octanol, 2-octanol, or 2-ethylhexanol; and most preferably the organic polar component is 2-ethylhexanol.

In a most preferred embodiment, the solvent composition comprises about 75 weight percent para-cymene and about 25 weight percent 2-ethylhexanol. The para-cymene can be manufactured from a number of turpentine-derived feedstocks, as well as from petrochemical sources. Atmospheric oxidation studies have shown that para-cymene stabilized with an anti-oxidant does not oxidize under normal conditions (immersion tank temperature 35°C), and even unstabilized para-cymene shows a very low susceptibility to oxidative attack. Table 1 compares the oxidative stability of para-cymene versus para-menthadienes in terms of peroxide and residue formation. The higher the peroxide and residue values are, the more susceptible to oxidative attack is the solvent. These tests were conducted under conditions of limited exchange of oxygen into the head space.

In the immersion-clean/steam-rinse process described hereinunder, it is important that the solvent exhibits a high degree of stability in hot water, i.e., hydrolytic stability. Our studies have confirmed that, unlike para-menthadienes, para-cymene is stable on prolonged exposure to boiling water (Table 2). These tests similarly were conducted under conditions of limited exchange of oxygen into the head space.

Steam distillation studies have shown that while 2-ethylhexanol does not appear to form an azeotrope with para-cymene, its boiling point is sufficiently similar to that of the para-cymene such that the distillate of the mixture is substantially uniform in constituency throughout the steam distillation recycle process (Table 4). In addition, solvent recovery was 99% for the para-cymene based solvent, and again reflects the greater stability of the para-cymene/2-ethylhexanol to hot water/steam distillation conditions. The weight ratio of solvent to water in steam distillation of the 2-ethylhexanol/para-cymene mixture is 40% solvent and 60% water. This high ratio of solvent will provide an efficient solvent recovery process by steam distillation.

Cleaning performance studies comparing para-cymene/2-ethylhexanol mixtures of varying concentrations, neat para-cymene, neat 2-ethylhexanol, para-menthadiene/terpene alcohol mixtures, and para-menthadienes, were conducted to determine the soil loading capacity of the relative solvents. Soils employed in the tests were a low-polarity light oil and an intermediate polarity abietic acid (component of rosin flux). The soils were selected to demonstrate broad cleaning performance over a range of low polarity and intermediate polarity soils. Figures 1 and 2 show how cleaning performance is affected by soil buildup in the solvent when removing abietic acid and light oil. It can be seen that in successive cleaning cycles, soil deposition is linear on reuse of the solvent.

The results surprisingly show that para-cymene/ 2-ethylhexanol mixtures give superior performance to both the para-menthadiene/terpene alcohol solvent mixture and para-menthadiene alone (Table 3). More surprising is that the performance of the mixture is significantly greater than would be predicted from the weighted average of the individual components. For example, a solvent composition having 90% para-cymene and 10% 2-ethylhexanol has relative soil loading capacities of 2.6 for abietic acid and 3.3 for light oil, compared to weighted average soil loading capacities of 0.25% for abietic acid and 2.6% for light oils.

The process is preferably conducted in multi-stage apparatus comprising one or more solvent-cleaning tanks and one or more rinsing tanks, including at least one azeotroping tank that has an outlet for volatile gases across which there is a condenser, including means for recovering condensate from the surfaces of the condenser. A solvent cleaning tank is, preferably, an immersion tank, i.e., it is designed for immersion of the dirty article into liquid solvent in the tank. If there is more than one solvent cleaning tank, the second tank can be another immersion tank or it can be designed for vapor contact and for recovery of condensed solvent off the article.

The azeotroping tank preferably has a reservoir at its base for containing aqueous medium and a heater for heating the aqueous medium. The condenser across the outlet (often an open top) of the azeotroping tank may be a cool heat exchanger, for instance cooled by cold water, equipped with means for collecting condensate that condenses onto its outer surfaces. The condenser should be constructed so as essentially to prevent the escape of any solvent from the tank. The condensate, comprising the solvent and water, preferably is subjected to phase separation, with the solvent being recycled to one of the solvent cleaning tanks, and the water either being run to waste or recycled to the azeotroping tank.

Although it is adequate for the apparatus to consist solely of a liquid solvent cleaning tank and an azeotroping rinse tank, particularly good results can be achieved when the apparatus consists of a liquid solvent cleaning tank, a second solvent cleaning tank wherein the articles are contacted with vaporized solvent in the presence of steam, and the azeotroping tank. The inclusion of steam with the solvent vapor reduces flammability, making the vapor cleaning of the articles safer. The mixed condensate of solvent and water can be recycled to the reservoir of this intermediate solvent cleaning tank without phase separation, or phase separation can be performed to facilitate control of the proportions of solvent and water in the reservoir.

Generally, contact of the articles with the solvent composition is by immersion in liquid solvent at a temperature that preferably is well below the flash point, for instance at least 10°C and often at least 20°C below the flash point of the solvent. The cleaning effectiveness of contact can be promoted by mechanical or, preferably, ultrasonic agitation of the solvent.

Contact of the article with the solvent composition generally results in a solvent residue being deposited on the surface of the article. Upon contact of the article with the aqueous medium, the solvent residue may form an azeotrope with the medium.

Azeotroping is generally conducted at a temperature of below 100°C. The surface from which azeotropic evaporation is to occur should preferably have an elevated temperature. The article may be pre-heated (either in the solvent treatment stages or previously), but often the article is heated to the desired azeotroping temperature by contact with the aqueous medium at an elevated temperature. Preferably the temperature of the surface is at least 60°C, usually at least 80°C, and preferably at least 95°C. Best results are achieved if the temperature is 98°C or, preferably, 100°C. The use of such temperatures facilitates removal of residue from the article surface. Indeed, it can be desirable to continue contact with hot aqueous medium after substantially all the azeotroping has been completed, primarily to raise the surface to a sufficiently high temperature as to promote final evaporation of the solvent residue.

A preferred method of performing the contact with the aqueous medium is to contact the contaminated surface with the aqueous medium at a temperature of at least about 98°C. Preferably, therefore, the aqueous medium is applied as steam, and this steam can either consist substantially only of water vapor or it can comprise water vapor and a spray of water very near to its boiling point. Thus, a boiling water spray (i.e., wet steam) is particularly preferred. The steam that condenses onto the article will remove from the article water-soluble residues that may not have been removed by the contact with solvent, examples being inorganic salts.

Best results are generally obtained when the azeotropic evaporation of the solvent residue is conducted while the article is exposed to a gaseous atmosphere. Often, therefore, the article is held in a stream of steam, and in particular by holding the article above a reservoir containing boiling water or other aqueous medium.

However, another method that can be conducted is to immerse the article in hot aqueous medium and then to lift the article out of the medium and allow azeotropic evaporation to occur off the surface of the article, due to the elevated temperature of the surface. For instance, the aqueous medium can have a temperature of from 60 to 99°C and the temperature must be such, having regard to the components in the aqueous medium and the solvent, that evaporation will occur off the surface when the article is lifted out of the aqueous medium.

In another method, the solvent-cleaned article (preferably pre-heated) is immersed in liquid aqueous medium and azeotropic evaporation of the solvent and water is conducted while the article remains immersed in the liquid.

An advantage of the presence of the aqueous medium, and in particular of processes in which the atmosphere above the aqueous medium is saturated by steam, is that this raises the flash point of the solvent in the ambient atmosphere. In the absence of the steam the solvent would frequently be above its flash point and so simple heating at the temperature of the steaming would be dangerous.

The safety of the process, and the performance, can be improved further by including additional materials in the steam atmosphere either to promote volatilization of the solvent or to raise the flash point of the combined vapors, or both. For instance, the flash point of the vapors will be raised if the steaming is conducted in the presence of an inert gas, such as nitrogen.

The process of the present invention can be applied to the treatment of soft surfaces such as fabrics and other fibrous materials, but preferably is applied to the treatment of hard surfaces such as glass, ceramics, and metal. The articles having these surfaces can be, for instance, machined metal parts or, preferably, printed circuit boards. The articles are held in the solvent cleaning tank and the subsequent tank in or on suitable containers, for instance by being suspended from a holder or by being supported in or on a holder, for instance a tray.

Apparatus suitable for use in the process of cleaning and rinsing articles as described above are illustrated in Figures 4-6. The apparatus of Figure 4 includes a solvent cleaning tank 2 filled with solvent 4 to the level shown, and provided with ultrasonic generators 12, an open top 6 for the introduction of articles 8 to be cleaned, and a heater 10.

A second tank 14 equipped with a heater 16 is filled with an aqueous medium 24 to the level shown and is connected by a weir 18 to a third tank 20 having a heater 22. The third tank 20 is filled to the level shown with aqueous medium 24 that is boiled by a heater 22 to generate steam. The combined tanks 14,20 are open to permit articles 8 to be immersed in the aqueous medium in the second tank 14 and then exposed to the steam in the third tank 20.

A condenser 26 extends around the open tanks 14,20 to collect azeotrope condensate in the collection trough 28. The condensate is carried to a vessel 32 in which the condensate separates into an aqueous phase 34 that is recycled by a line 36 to the second tank 14, and a solvent phase 38 that is recycled to the solvent cleaning tank 2 by a line 40.

Means (not shown) are provided for moving the articles 8 in sequence through the tanks.

Figure 5 is a cross-sectional view of the condenser 26 and collection trough 28 which extend around the open tanks 14,20 to collect the azeotrope condensate 30 as -it is evaporated from the article surface.

Other embodiments utilizing the basic concept of Figure 4 are possible, wherein the solvent cleaning tank 2 is

used in conjunction with only the aqueous medium immersion tank 14 being used for removal of the solvent residue from the surface of the article. Likewise, the solvent cleaning tank 2 could be used in conjunction with only the steaming tank 20 for removal of the solvent residue from the article surface.

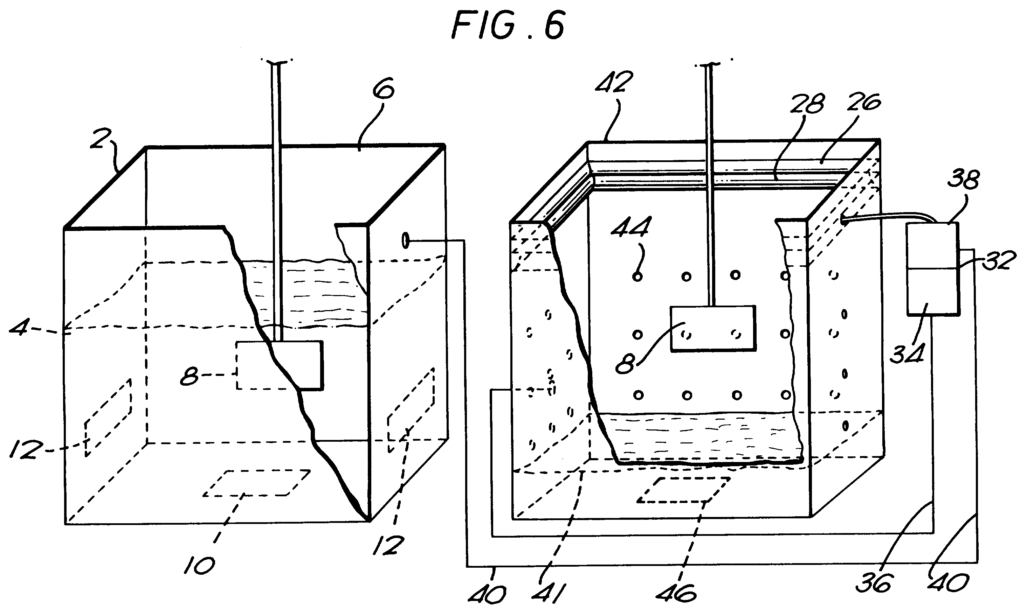

In Figure 6 is shown a preferred embodiment of the solvent-cleaning/steam-rinse process wherein the liquid solvent cleaning tank 2 is used in conjunction with a steam/hot water spray tank 42. The article 8 is removed from the solvent tank 2 and suspended in the steam/spray tank 42 which is filled with water 41 to the level shown, which water is heated to boiling by a heater 46. The article 8 is then subjected to steam, which is generated from the heated water 41, and a spray of near-boiling water which is sprayed from nozzles 44 located along the side and perimeter of the tank 42. The tank is equipped with a condenser 26 and collection trough 28 for collecting the azeotrope condensate and transferring the condensate to a vessel 32, wherein the condensate separates into an aqueous phase 34 that is recycled by a line 36 to the spray tank 42, and a solvent phase 38 that is recycled to the solvent cleaning tank 2 by a line 40.

Example 1: Oxidation Tests

The solvent to be tested (200 ml) was charged to a 500 ml single neck (B19) flask fitted with a single surface condenser and placed in a water bath maintained at 35°C. A sample (40 ml) of the solvent was withdrawn from the flask on day one, then subsequently every 5 days over the 21-day period. Samples were analyzed for peroxide content (iodometric titration) and residue (Kugelrohr distillation).

TABLE 1

| Comparison of Oxidative Stability of Para-cymene and Para-menthadienes | | |
|---|---|---|
| | Peroxide Value (uM/L) | Residue (wt%) |
| para-cymene (stabilized) | 2 | 0 |
| para-cymene (unstabilized) | 8 | 0.1 |
| para-menthadienes (stabilized) | >20 | 13 |

Example 2: Hydrolytic Stability Tests

The solvent to be tested (200g) was charged with distilled water (300g) to a 1L flask fitted with a mechanical stirrer, thermocouple and soxhlet/condenser. The stirred mixture was heated to reflux with return of the condensate via the soxhlet. Gentle reflux was maintained over a 70-hour test period.

At the end of the test period the oil was analyzed for residue (Kugelrohr distillation) and peroxide formation (iodometric titration), and also analyzed by gas/liquid chromatography.

TABLE 2

| Comparison of Hydrolytic Stability of para-cymene and para-menthadienes | |
|---|---|
| | Residue (wt%) |
| para-cymene | 0.1 |
| para-menthadiene | 2.0 |

Example 3: High Soil Loading Capacity

Laboratory testing of overall cleaning performance was completed in the following manner:

A. A weighed, flat 60 x 55mm stainless steel test piece was coated with between 0.2 and 0.5g of soil (either rosin acid or light oil).
B. The soiled test piece was then immersed in 600 ml of solvent at 35°C and the mixture mechanically agitated for 12 minutes.
C. The test piece was withdrawn and most of the solvent was allowed to drain back into the cleaning solvent bath.
D. Remaining solvent residue was removed by holding the horizontal test piece above a steam bath for 3 minutes.
E. Test pieces were then dried in an oven for 5 minutes at 120°C, cooled, and weighed.
F. Steps A to E were repeated, with the same solvent volume being employed for the cleaning step, until greater than 1 mg of soil was retained on the test piece.

The solvent performance is then expressed in terms of the solvent soil loading capacity (S) as follows:

$$S = \frac{W \times C}{V \times P} \times 100$$

where W = average weight of soil removed from the test piece per cleaning cycle;
C = last successful cleaning cycle;
V = solvent volume;
P = solvent density.

Results for cleaning abietic acid and light oil are described in Table 3, and expressed graphically in Figures 1 and 2. The small case reference letters found in Figures 1 and 2 correspond to the respective solvent compositions contained in Table 3. The 1 mg residual soil criteria corresponds to 99.7% abietic acid removal and 99.5% light oil removal.

TABLE 3

| Comparison of Solvent Performance in the Removal of Low and Intermediate Polarity Soils | | | |
|---|---|---|---|
| | | Soil Loading Capacity (wt% Soil/wt% Solvent) | |
| | Solvent | Abietic Acid | Light Oil |
| a. | Neat para-cymene | 0.1 | 2.7 |
| b. | Neat 2-ethylhexanol | 1.6 | 2.1 |
| c. | 95% para-cymene<br>5% 2-ethylhexanol | 1.9 | --- |
| d. | 90% para-cymene<br>10% 2-ethylhexanol | 2.6 | 3.3 |
| e. | 75% para-cymene<br>25% 2-ethylhexanol | 3.3 | --- |
| f. | 50% para-cymene<br>50% 2-ethylhexanol | 2.7 | --- |
| g. | 25% para-cymene<br>75% 2-ethylhexanol | 2.4 | --- |
| h. | 10% para-cymene<br>90% 2-ethylhexanol | 1.8 | --- |
| i. | para-menthadienes | 0.5 | 1.4 |
| j. | 90% para-menthadienes<br>10% terpene alcohols | 0.9 | 2.6 |

Example 4: Steam Co-distillability

Solvent (500g; 90% para-cymene/10% 2-ethylhexanol) and water (2000g) was charged to a 5L, 3-necked flask fitted with stirrer, thermometer and distillation head. The mixture was heated to reflux and oil/water fractions were separated into oil and aqueous layers and the layers weighed to determine the oil:water ratio throughout the distillation. The oil composition was determined by gas/liquid chromatography analysis. Results in Table 4 show that the percent composition relative to the para-cymene and 2-ethylhexanol is substantially unchanged with nearly 95% of solvent recovered.

TABLE 4

| Steam Distillation of Para-cymene/2-ethylhexanol Oil Composition | | | |
|---|---|---|---|
| Fraction Number | Cumulative Weight % of Total Charge | % Composition | |
| | | Para-cymene | 2-ethylhexanol |
| 1 | 7.1 | 88.4 | 7.7 |
| 2 | 14.3 | 88.5 | 7.8 |
| 3 | 21.4 | 88.5 | 7.9 |

TABLE 4 (continued)

| Steam Distillation of Para-cymene/2-ethylhexanol Oil Composition | | | |
|---|---|---|---|
| Fraction Number | Cumulative Weight % of Total Charge | % Composition | |
| | | Para-cymene | 2-ethylhexanol |
| 4 | 28.5 | 88.7 | 8.0 |
| 5 | 35.5 | 88.5 | 8.1 |
| 6 | 42.7 | 88.5 | 8.3 |
| 7 | 49.9 | 88.5 | 8.4 |
| 8 | 56.9 | 88.4 | 8.6 |
| 9 | 64.3 | 88.4 | 8.8 |
| 10 | 71.4 | 88.3 | 9.0 |
| 11 | 78.6 | 88.1 | 9.5 |
| 12 | 86.0 | 87.7 | 10.0 |
| 13 | 93.2 | 86.7 | 11.3 |
| 14 | 98.8 | 78.8 | 19.4 |
| 15 | 99.0 | 46.4 | 51.9 |

Example 5: Chemical Stability and Co-distillability of Solvent Components for Solvent Recycle

The following processing conditions were employed in an immersion-clean/steam-rinse cleaning process:

A. The dirty article was immersed in an agitated solvent tank for 10 minutes at 35°C.
B. The article was then transferred to a hot water rinse tank, held at 98-100°C to remove residual solvent as a steam azeotrope.
C. The article was then dried in hot air.
D. Solvent collected from both the immersion tank and hot water tank was recovered for recycle by steam distillation.

The process was operated over three consecutive days in which time many articles were cleaned. Both the immersion tank and rinse tank were covered with loose-fitting lids, such that the exchange of air in the tank headspace mostly occurred during transfer of articles between tanks when the lids were temporarily removed. The following differences were observed during cleaning with two solvent mixtures:

(1) Para-menthadiene and Terpene Alcohol Mixture:

The solvent mixture in the immersion tank underwent chemical changes in that 2% terpene epoxides and 5% polymeric residues were formed.

Residual solvent on the surface of the water in the rinse tank became resinous and inhibited the evaporation of both water and solvent.

An additional 5% residue was formed when the solvent was recovered by steam distillation, and the para-menthadiene components were recovered preferentially over the terpene alcohol components because of lower boiling points.

All these chemical changes indicate a high susceptibility of the terpenes present in the formulation to air oxidation and/or hot water instability, which reduces their effectiveness in cleaning processes. In particular, deposition of polymeric residues onto the "cleaned" article will nullify the cleaning process.

(2) Para-cymene and 2-Ethylhexanol Solvent Mixture:

No polymeric residue or epoxides were formed in any of the immersion tank, rinse tank, or steam distillation recycle process stages. In addition, the para-cymene and 2-ethylhexanol components were recovered at the same rates during the steam distillation solvent recovery step.

## Claims

**Claims for the following Contracting States : AT, BE, CH, LI, DE, DK, FR, GB, GR, IT, LU, NL, SE**

1. A process for cleaning a dirty article, the process comprising the steps of:

   - contacting the dirty article with a solvent composition comprising:

     a $C_9$-$C_{12}$ aromatic hydrocarbon of formula

     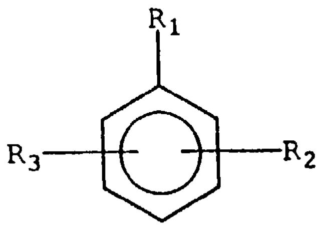

     wherein $R_1$ is $CH_3$, $R_2$ is hydrogen or a straight-chained or branched lower alkyl, and $R_3$ is hydrogen or a $C_1$-$C_5$ straight-chained alkyl; and
     a $C_7$-$C_{10}$ organic polar component,
     wherein the solvent composition comprises from about 99 to about 1 weight percent of the aromatic hydrocarbon and from about 1 to about 99 weight percent of the organic polar component;
     whereby the contact of the dirty article with the solvent composition results in a solvent residue being deposited on a surface of the article; and

   - contacting the article having the solvent residue on its surface with an aqueous medium such that the solvent residue is removed by steam distillation, or forms an azeotrope with the aqueous medium, and said azeotrope is removed from the surface of the article by azeotropicevaporation; wherein the solvent composition distils over a very narrow range, or forms an azeotrope boiling at a single temperature.

2. A process according to claim 1 wherein the azeotrope is condensed, an organic solvent phase is separated, and the separated phase is recycled for subsequent cleaning of a dirty article.

3. A process according to claim 1 or claim 2 wherein the azeotrope is evaporated in a vessel, which vessel. contains the aqueous medium in its base, and has a heater for heating the aqueous medium, and an outlet for evaporated azeotrope, and a condenser across the outlet on which the azeotrope is condensed.

4. A process according to any preceding claim conducted in a multi-stage apparatus, the apparatus comprising a tank for immersion of the dirty article in the solvent composition and a tank in which the azeotrope is evaporated, and including means for condensing the azeotrope, separating the solvent from the aqueous medium, and recycling the solvent to the immersion tank.

5. A process according to any preceding claim wherein azeotrope formation is conducted at from about 60-100°C.

6. A process according to any preceding claim wherein the aqueous medium has a temperature of at least 98°C.

7. A process according to any preceding claim wherein the aqueous medium is steam.

8. A process according to claim 7 wherein the steam comprises water vapor and a spray of water at a temperature of at least about 98°C.

9. A process according to any preceding claim wherein azeotropic evaporation of the solvent residue is conducted while the article is exposed to a gaseous atmosphere.

10. A process according to any preceding claim wherein the aromatic hydrocarbon is para-cymene, meta-cymene, a trimethylbenzene or an ethyltoluene.

**11.** A process according to any preceding claim wherein the organic polar component is 1-octanol, 2-octanol or 2-ethylhexanol.

**12.** A solvent composition, consisting only of: at least one $C_9$-$C_{12}$ aromatic hydrocarbon of formula

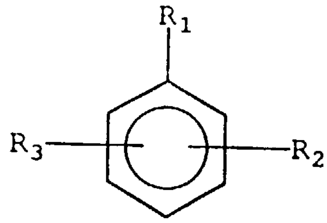

wherein $R_1$ is $CH_3$, $R_2$ is hydrogen or a straight-chained or branched lower alkyl, and $R_3$ is hydrogen or a $C_1$-$C_5$ straight-chained alkyl; and a $C_7C_{10}$ organic polar component, wherein the solvent composition comprises from about 1 to about 99 weight percent of the organic polar component; and wherein the solvent composition distils over a very narrow range, or forms an azeotrope boiling at a single temperature.

**13.** A solvent composition, consisting only of: at least one $C_9$-$C_{12}$ aromatic hydrocarbon of formula

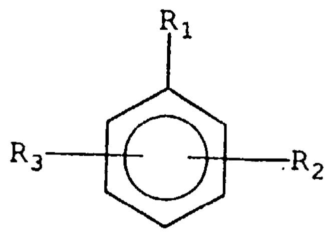

wherein $R_1$ is $CH_3$, $R_2$ is hydrogen or a straight-chained or branched lower alkyl, and $R_3$ is hydrogen or a $C_1$-$C_5$ straight-chained alkyl;

a $C_7$-$C_{10}$ organic polar component;
a portion of water sufficient to form a
water-in-oil emulsion; and
optionally, a surfactant to assist in forming said water-in-oil emulsion; wherein the solvent composition comprises from about 1 to about 99 weight percent of the organic polar component; and wherein the solvent composition distils over a very narrow range, or forms an azeotrope boiling at a single temperature.

**14.** A composition according to claim 12 or claim 13 wherein the aromatic hydrocarbon is para-cymene, meta-cymene, a trimethylbenzene or an ethyltoluene.

**15.** A composition according to claim 14 wherein the aromatic hydrocarbon is para-cymene.

**16.** A composition according to any one of claims 12 to 15 wherein the organic polar component is an alcohol, an ester, an amine or a ketone.

**17.** A composition according to claim 16 wherein the organic polar component is 1-octanol, 2-octanol, or 2-ethylhexanol.

**18.** A composition according to claim 17 wherein the organic polar component is 2-ethylhexanol.

**19.** A composition according to any one of claims 12 to 18 comprising from about 95 to about 5 weight percent of the aromatic hydrocarbon, and from about 5 to about 95 weight percent of the organic polar component.

**20.** A composition according to claim 19 comprising about 75 weight percent of the aromatic hydrocarbon and about 25 weight percent of the organic polar component.

**21.** Use of a composition as claimed in any one of claims 12 to 20 in a process for cleaning a dirty article according to any of claims 1 to 11.

**Claims for the following Contracting State : ES**

**1.** A process for cleaning a dirty article, the process comprising the steps of:

- contacting the dirty article with a solvent composition comprising:

  a $C_9$-$C_{12}$ aromatic hydrocarbon of formula

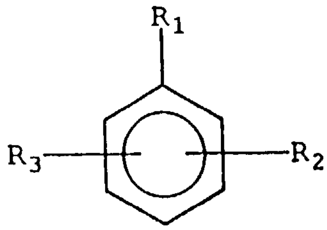

  wherein $R_1$ is $CH_3$, $R_2$ is hydrogen or a straight-chained or branched lower alkyl, and $R_3$ is hydrogen or a $C_1$-$C_5$ straight-chained alkyl; and
  a $C_7$-$C_{10}$ organic polar component,
  wherein the solvent composition comprises from about 99 to about 1 weight percent of the aromatic hydrocarbon and from about 1 to about 99 weight percent of the organic polar component;
  whereby the contact of the dirty article with the solvent composition results in a solvent residue being deposited on a surface of the article; and

- contacting the article having the solvent residue on its surface with an aqueous medium such that the solvent residue is removed by steam distillation, or forms an azeotrope with the aqueous medium, and said azeotrope is removed from the surface of the article by azeotropicevaporation; wherein the solvent composition distils over a very narrow range, or forms an azeotrope boiling at a single temperature.

**2.** A process according to claim 1 wherein the azeotrope is condensed, an organic solvent phase is separated, and the separated phase is recycled for subsequent cleaning of a dirty article.

**3.** A process according to claim 1 or claim 2 wherein the azeotrope is evaporated in a vessel, which vessel contains the aqueous medium in its base, and has a heater for heating the aqueous medium, and an outlet for evaporated azeotrope, and a condenser across the outlet on which the azeotrope is condensed.

**4.** A process according to any preceding claim conducted in a multi-stage apparatus, the apparatus comprising a tank for immersion of the dirty article in the solvent composition and a tank in which the azeotrope is evaporated, and including means for condensing the azeotrope, separating the solvent from the aqueous medium, and recycling the solvent to the immersion tank.

**5.** A process according to any preceding claim wherein azeotrope formation is conducted at from about 60-100°C.

**6.** A process according to any preceding claim wherein the aqueous medium has a temperature of at least 98°C.

**7.** A process according to any preceding claim wherein the aqueous medium is steam.

**8.** A process according to claim 7 wherein the steam comprises water vapor and a spray of water at a temperature of at least about 98°C.

**9.** A process according to any preceding claim wherein azeotropic evaporation of the solvent residue is conducted while the article is exposed to a gaseous atmosphere.

**10.** A process according to any preceding claim wherein the aromatic hydrocarbon is para-cymene, meta-cymene, a trimethylbenzene or an ethyltoluene.

**11.** A process according to any preceding claim wherein the organic polar component is 1-octanol, 2-octanol or 2-ethylhexanol.

**12.** A process for preparing a solvent composition which distils over a very narrow range, or forms an azeotrope boiling at a single temperature, said process consisting of admixing at least one $C_9$-$C_{12}$ aromatic hydrocarbon of formula

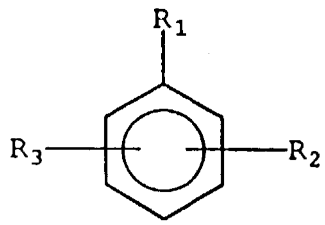

wherein $R_1$ is $CH_3$, $R_2$ is hydrogen or a straight-chained or branched lower alkyl, and $R_3$ is hydrogen or a $C_1$-$C_5$ straight-chained alkyl; and a $C_7$-$C_{10}$ organic polar component, wherein the solvent composition comprises from about 1 to about 99 weight percent of the organic polar component.

**13.** A process for preparing a solvent composition which distils over a very narrow range, or forms an azeotrope boiling at a single temperature, said process consisting of admixing at least one $C_9$-$C_{12}$ aromatic hydrocarbon of formula

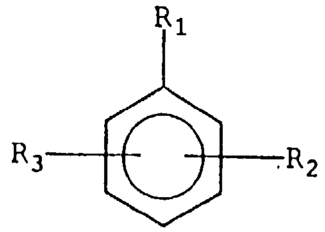

wherein $R_1$ is $CH_3$, $R_2$ is hydrogen or a straight-chained or branched lower alkyl, and $R_3$ is hydrogen or a $C_1$-$C_5$ straight-chained alkyl;

a $C_7$-$C_{10}$ organic polar component;
a portion of water sufficient to form a
water-in-oil emulsion; and
optionally, a surfactant to assist in forming said water-in-oil emulsion; wherein the solvent composition comprises from about 1 to about 99 weight percent of the organic polar component.

**14.** A process according to claim 12 or claim 13 wherein the aromatic hydrocarbon is para-cymene, meta-cymene, a trimethylbenzene or an ethyltoluene.

**15.** A process according to claim 14 wherein the aromatic hydrocarbon is para-cymene.

**16.** A process according to any one of claims 12 to 15 wherein the organic polar component is an alcohol, an ester, an amine or a ketone.

**17.** A process according to claim 16 wherein the organic polar component is 1-octanol, 2-octanol, or 2-ethylhexanol.

**18.** A process according to claim 17 wherein the organic polar component is 2-ethylhexanol.

**19.** A process according to any one of claims 12 to 18 wherein the solvent composition produced comprises from about 95 to about 5 weight percent of the aromatic hydrocarbon, and from about 5 to about 95 weight percent of the organic polar component.

**20.** A process according to claim 19 wherein the solvent composition produced comprises about 75 weight percent of the aromatic hydrocarbon and about 25 weight percent of the organic polar component.

**21.** Use of the product of a process as claimed in any one of claims 12 to 20 in a process for cleaning a dirty article according to any of claims 1 to 11.

## Patentansprüche

### Patentansprüche für folgende Vertragsstaaten : AT, BE, CH, LI, DE, DK, FR, GB, GR, IT, LU, NL, SE

**1.** Verfahren zum Reinigen eines verschmutzten Artikels, wobei man:

- den verschmutzten Artikel mit einer Lösungsmittelzusammensetzung in Kontakt bringt, die

  einen aromatischen $C_9$-$C_{12}$-Kohlenwasserstoff der Formel

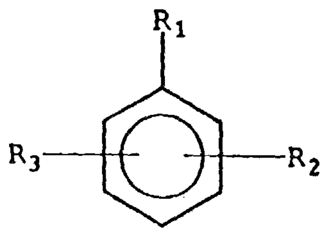

  worin $R_1$ für $CH_3$ steht, $R_2$ für Wasserstoff oder eine geradkettige oder verzweigte Niedrigalkylgruppe steht und $R_3$ für Wasserstoff oder eine geradkettige $C_1$-$C_5$-Alkylgruppe steht; und eine organische, polare $C_7$-$C_{10}$-Komponente umfaßt,
  wobei die Lösungsmittelzusammensetzung etwa 99 bis etwa 1 Gew.-% des aromatischen Kohlenwasserstoffs und etwa 1 bis etwa 99 Gew.-% der organischen, polaren Komponente umfaßt;
  wobei das Kontaktieren des verschmutzten Artikels mit der Lösungsmittelzusammensetzung zur Ablagerung eines Lösungsmittelrückstandes auf einer Oberfläche des Artikels führt; und

- den Artikel, der den Lösungsmittelrückstand auf seiner Oberfläche aufweist, mit einem wäßrigen Medium in Kontakt bringt, so daß der Lösungsmittelrückstand durch Dampfdestillation entfernt wird oder ein Azeotrop mit dem wäßrigen Medium bildet und das Azeotrop durch azeotrope Verdampfung von der Oberfläche des Artikels entfernt wird; wobei die Lösungsmittelzusammensetzung über einen sehr engen Bereich destilliert oder ein Azeotrop bildet, welches bei einer bestimmten Temperatur siedet.

**2.** Verfahren nach Anspruch 1, wobei das Azeotrop kondensiert, eine organische Lösungsmittelphase abgetrennt und die abgetrennte Phase für die anschließende Reinigung eines verschmutzten Artikels recycliert wird.

**3.** Verfahren nach Anspruch 1 oder 2, wobei das Azeotrop in einem Gefäß verdampft wird, das das wäßrige Medium im Bodenbereich enthält und eine Heizvorrichtung zum Erhitzen des wäßrigen Mediums und eine Auslaßöffnung für verdampftes Azeotrop sowie einen Kondensator gegenüber der Auslaßöffnung aufweist, an dem das Azeotrop kondensiert wird.

**4.** Verfahren nach einem der vorhergehenden Ansprüche, welches in einer mehrstufigen Vorrichtung durchgeführt wird, wobei die Vorrichtung einen Behälter zum Eintauchen des verschmutzten Artikels in die Lösungsmittelzusammensetzung und einen Behälter, worin das Azeotrop verdampft wird, umfaßt und Mittel zum Kondensieren des Azeotrops, zum Abtrennen des Lösungsmittels von dem wäßrigen Medium und zur Rückführung des Lösungsmittels in den Tauchbehälter aufweist.

**5.** Verfahren nach einem der vorhergehenden Ansprüche, wobei die Bildung des Azeotrops bei etwa 60-100°C erfolgt.

**6.** Verfahren nach einem der vorhergehenden Ansprüche, wobei das wäßrige Medium eine Temperatur von wenigstens 98°C aufweist.

**7.** Verfahren nach einem der vorhergehenden Ansprüche, wobei das wäßrige Medium Dampf ist.

**8.** Verfahren nach Anspruch 7, wobei der Dampf Wasserdampf und zerstäubtes Wasser mit einer Temperatur von wenigstens etwa 98°C umfaßt.

**9.** Verfahren nach einem der vorhergehenden Ansprüche, wobei die azeotrope Verdampfung des Lösungsmittelrückstands durchgeführt wird, während der Artikel einer gasförmigen Atmosphäre ausgesetzt wird.

**10.** Verfahren nach einem der vorhergehenden Ansprüche, wobei der aromatische Kohlenwasserstoff para-Cymen, meta-Cymen, Trimethylbenzol oder Ethyltoluol ist.

**11.** Verfahren nach einem der vorhergehenden Ansprüche, wobei die organische, polare Komponente 1-Octanol, 2-Octanol oder 2-Ethylhexanol ist.

**12.** Lösungsmittelzusammensetzung, die nur besteht aus: wenigstens einem aromatischen $C_9$-$C_{12}$-Kohlenwasserstoff der Formel

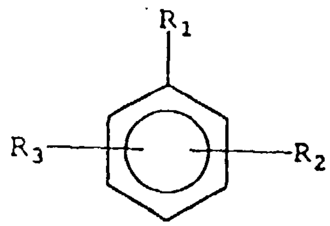

worin $R_1$ für $CH_3$ steht, $R_2$ für Wasserstoff oder eine geradkettige oder verzweigte Niedrigalkylgruppe steht und $R_3$ für Wasserstoff oder eine geradkettige $C_1$-$C_5$-Alkylgruppe steht; und einer organischen, polaren $C_7$-$C_{10}$-Komponente, wobei die Lösungsmittelzusammensetzung etwa 1 bis etwa 99 Gew.-% der organischen, polaren Komponente umfaßt; und wobei die Lösungsmittelzusammensetzung über einen sehr engen Bereich destilliert oder ein Azeotrop bildet, welches bei einer bestimmten Temperatur siedet.

**13.** Lösungsmittelzusammensetzung, lediglich bestehend aus: wenigstens einem aromatischen $C_9$-$C_{12}$-Kohlenwasserstoff der Formel

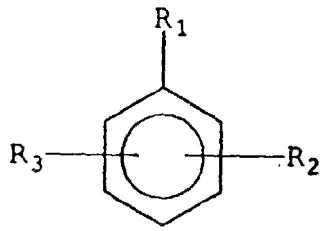

worin $R_1$ für $CH_3$ steht, $R_2$ für Wasserstoff oder eine geradkettige oder verzweigte Niedrigalkylgruppe steht und $R_3$ für Wasserstoff oder eine geradkettige $C_1$-$C_5$-Alkylgruppe steht;

einer organischen, polaren $C_7$-$C_{10}$-Komponente;
Wasser in einer Menge, die ausreicht, um eine Wasser-in-Öl-Emulsion zu bilden; und
gegebenenfalls ein oberflächenaktives Mittel, welches die Bildung der Wasser-in-Öl-Emulsion unterstützt; wobei die Lösungsmittelzusammensetzung etwa 1 bis etwa 99 Gew.-% der organischen, polaren Komponente umfaßt; und wobei die Lösungsmittelzusammensetzung über einen sehr engen Bereich destilliert oder ein Azeotrop bildet, welches bei einer bestimmten Temperatur siedet.

**14.** Zusammensetzung nach Anspruch 12 oder 13, wobei der aromatische Kohlenwasserstoff para-Cymen, meta-Cymen, Trimethylbenzol oder Ethyltoluol ist.

**15.** Zusammensetzung nach Anspruch 14, wobei der aromatische Kohlenwasserstoff para-Cymen ist.

**16.** Zusammensetzung nach einem der Ansprüche 12 bis 15, wobei die organische, polare Komponente ein Alkohol, ein Ester, ein Amin oder ein Keton ist.

**17.** Zusammensetzung nach Anspruch 16, wobei die organische, polare Komponente 1-Octanol, 2-Octanol oder 2-Ethylhexanol ist.

**18.** Zusammensetzung nach Anspruch 17, wobei die organische, polare Komponente 2-Ethylhexanol ist.

**19.** Zusammensetzung nach einem der Ansprüche 12 bis 18, umfassend etwa 95 bis etwa 5 Gew.-% des aromatischen Kohlenwasserstoffs und etwa 5 bis etwa 95 Gew.-% der organischen, polaren Komponente.

**20.** Zusammensetzung nach Anspruch 19, umfassend etwa 75 Gew.-% des aromatischen Kohlenwasserstoffs und etwa 25 Gew.-% der organischen, polaren Komponente.

**21.** Verwendung einer Zusammensetzung nach einem der Ansprüche 12 bis 20 in einem Verfahren zur Reinigung eines verschmutzten Artikels nach einem der Ansprüche 1 bis 11.

**Patentansprüche für folgenden Vertragsstaat : ES**

**1.** Verfahren zum Reinigen eines verschmutzten Artikels, wobei man:

- den verschmutzten Artikel mit einer Lösungsmittelzusammensetzung in Kontakt bringt, die

  einen aromatischen $C_9$-$C_{12}$-Kohlenwasserstoff der Formel

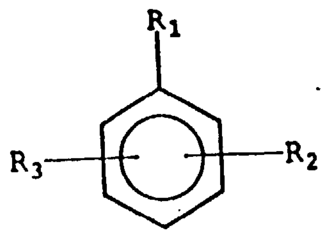

  worin $R_1$ für $CH_3$ steht, $R_2$ für Wasserstoff oder eine geradkettige oder verzweigte Niedrigalkylgruppe steht und $R_3$ für Wasserstoff oder eine geradkettige $C_1$-$C_5$-Alkylgruppe steht; und

  eine organische, polare $C_7$-$C_{10}$-Komponente umfaßt,

  wobei die Lösungsmittelzusammensetzung etwa 99 bis etwa 1 Gew.-% des aromatischen Kohlenwasserstoffs und etwa 1 bis etwa 99 Gew.-% der organischen, polaren Komponente umfaßt;

  wobei das Kontaktieren des verschmutzten Artikels mit der Lösungsmittelzusammensetzung zur Ablagerung eines Lösungsmittelrückstandes auf einer Oberfläche des Artikels führt; und

- den Artikel, der den Lösungsmittelrückstand auf seiner Oberfläche aufweist, mit einem wäßrigen Medium in Kontakt bringt, so daß der Lösungsmittelrückstand durch Dampfdestillation entfernt wird oder ein Azeotrop mit dem wäßrigen Medium bildet und das Azeotrop durch azeotrope Verdampfung von der Oberfläche des Artikels entfernt wird; wobei die Lösungsmittelzusammensetzung über einen sehr engen Bereich destilliert oder ein Azeotrop bildet, welches bei einer bestimmten Temperatur siedet.

**2.** Verfahren nach Anspruch 1, wobei das Azeotrop kondensiert, eine organische Lösungsmittelphase abgetrennt und die abgetrennte Phase für die anschließende Reinigung eines verschmutzten Artikels recycliert wird.

**3.** Verfahren nach Anspruch 1 oder 2, wobei das Azeotrop in einem Gefäß verdampft wird, das das wäßrige Medium im Bodenbereich enthält und eine Heizvorrichtung zum Erhitzen des wäßrigen Mediums und eine Auslaßöffnung für verdampftes Azeotrop sowie einen Kondensator gegenüber der Auslaßöffnung aufweist, an dem das Azeotrop kondensiert wird.

**4.** Verfahren nach einem der vorhergehenden Ansprüche, welches in einer mehrstufigen Vorrichtung durchgeführt wird, wobei die Vorrichtung einen Behälter zum Eintauchen des verschmutzten Artikels in die Lösungsmittelzusammensetzung und einen Behälter, worin das Azeotrop verdampft wird, umfaßt und Mittel zum Kondensieren des Azeotrops, zum Abtrennen des Lösungsmittels von dem wäßrigen Medium und zur Rückführung des Lösungsmittels in den Tauchbehälter aufweist.

**5.** Verfahren nach einem der vorhergehenden Ansprüche, wobei die Bildung des Azeotrops bei etwa 60-100°C erfolgt.

**6.** Verfahren nach einem der vorhergehenden Ansprüche, wobei das wäßrige Medium eine Temperatur von wenigstens 98°C aufweist.

7. Verfahren nach einem der vorhergehenden Ansprüche, wobei das wäßrige Medium Dampf ist.

8. Verfahren nach Anspruch 7, wobei der Dampf Wasserdampf und zerstäubtes Wasser mit einer Temperatur von wenigstens etwa 98°C umfaßt.

9. Verfahren nach einem der vorhergehenden Ansprüche, wobei die azeotrope Verdampfung des Lösungsmittelrückstands durchgeführt wird, während der Artikel einer gasförmigen Atmosphäre ausgesetzt wird.

10. Verfahren nach einem der vorhergehenden Ansprüche, wobei der aromatische Kohlenwasserstoff para-Cymen, meta-Cymen, Trimethylbenzol oder Ethyltoluol ist.

11. Verfahren nach einem der vorhergehenden Ansprüche, wobei die organische, polare Komponente 1-Octanol, 2-Octanol oder 2-Ethylhexanol ist.

12. Verfahren zur Herstellung einer Lösungsmittelzusammensetzung, die über einen sehr engen Bereich destilliert oder ein Azeotrop bildet, welches bei einer bestimmten Temperatur siedet, wobei man wenigstens einen aromatischen $C_9$-$C_{12}$-Kohlenwasserstoff der Formel

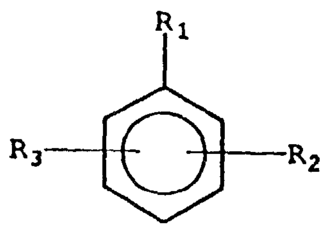

worin $R_1$ für $CH_3$ steht, $R_2$ für Wasserstoff oder eine geradkettige oder verzweigte Niedrigalkylgruppe steht und $R_3$ für Wasserstoff oder eine geradkettige $C_1$-$C_5$-Alkylgruppe steht, und eine organische, polare $C_7$-$C_{10}$-Komponente miteinander vermischt, wobei die Lösungsmittelzusammensetzung etwa 1 bis etwa 99 Gew.-% der organischen, polaren Komponente umfaßt.

13. Verfahren zur Herstellung einer Lösungsmittelzusammensetzung, die über einen sehr engen Bereich destilliert oder ein Azeotrop bildet, welches bei einer bestimmten Temperatur siedet, wobei man wenigstens einen aromatischen $C_9$-$C_{12}$-Kohlenwasserstoff der Formel

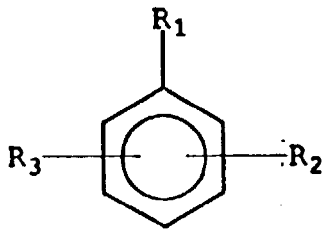

worin $R_1$ für $CH_3$ steht, $R_2$ für Wasserstoff oder eine geradkettige oder verzweigte Niedrigalkylgruppe steht und $R_3$ für Wasserstoff oder eine geradkettige $C_1$-$C_5$-Alkylgruppe steht, mit

einer organischen, polaren $C_7$-$C_{10}$-Komponente,
Wasser in einer Menge, die ausreicht, um eine Wasser-in-Öl-Emulsion zu bilden und
gegebenenfalls einem oberflächenaktiven Mittel, welches die Bildung der Wasser-in-Öl-Emulsion unterstützt,
vermischt, wobei die Lösungsmittelzusammensetzung etwa 1 bis etwa 99 Gew.-% der organischen, polaren Komponente umfaßt.

14. Verfahren nach Anspruch 12 oder 13, wobei der aromatische Kohlenwasserstoff para-Cymen, meta-Cymen, Trimethylbenzol oder Ethyltoluol ist.

15. Verfahren nach Anspruch 14, wobei der aromatische Kohlenwasserstoff para-Cymen ist.

16. Verfahren nach einem der Ansprüche 12 bis 15, wobei die organische, polare Komponente ein Alkohol, ein Ester, ein Amin oder ein Keton ist.

**17.** Verfahren nach Anspruch 16, wobei die organische, polare Komponente 1-Octanol, 2-Octanol oder 2-Ethylhexanol ist.

**18.** Verfahren nach Anspruch 17, wobei die organische, polare Komponente 2-Ethylhexanol ist.

**19.** Verfahren nach einem der Ansprüche 12 bis 18, wobei die erhaltene Lösungsmittelzusammensetzung etwa 95 bis etwa 5 Gew.-% des aromatischen Kohlenwasserstoffs und etwa 5 bis etwa 95 Gew.-% der organischen, polaren Komponente umfaßt.

**20.** Verfahren nach Anspruch 19, wobei die erhaltene Lösungsmittelzusammensetzung etwa 75 Gew.-% des aromatischen Kohlenwasserstoffs und etwa 25 Gew.-% der organischen, polaren Komponente umfaßt.

**21.** Verwendung des Produktes eines Verfahrens nach einem der Ansprüche 12 bis 20 in einem Verfahren zur Reinigung eines verschmutzten Artikels nach einem der Ansprüche 1 bis 11.

**Revendications**

**Revendications pour les Etats contractants suivants : AT, BE, CH, LI, DE, DK, FR, GB, GR, IT, LU, NL, SE**

**1.** Procédé de nettoyage d'un article sale, le procédé comprenant les étapes consistant à :

- mettre en contact l'article sale avec une composition de solvant comprenant :

  un hydrocarbure aromatique en $C_9$ à $C_{12}$ répondant à la formule

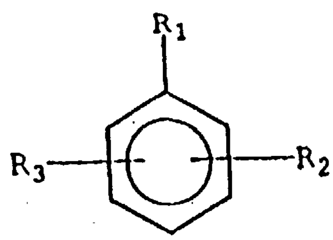

  dans laquelle $R_1$ est $CH_3$, $R_2$ est un atome d'hydrogène ou un groupe alkyle inférieur à chaîne linéaire ou ramifiée et $R_3$ est un atome d'hydrogène ou un groupe alkyle à chaîne linéaire en $C_1$ à $C_5$ ; et
  un constituant polaire organique en $C_7$ à $C_{10}$,
  la composition de solvant comprenant environ 99 à environ 1 % en poids de l'hydrocarbure aromatique et d'environ 1 à environ 99 % en poids du constituant polaire organique ;
  de sorte que le contact de l'article sale avec la composition de solvant conduit à un résidu de solvant qui est déposé sur une surface de l'article ; et

- mettre en contact l'article ayant le résidu de solvant sur sa surface avec un milieu aqueux tel que le résidu de solvant soit éliminé par entraînement par la vapeur, ou forme un azéotrope avec le milieu aqueux et cet azéotrope soit éliminé de la surface de l'article par évaporation azéotropique ; la composition de solvant distillant dans un intervalle très étroit, ou formant un azéotrope bouillant à une température unique.

**2.** Procédé selon la revendication 1, dans lequel l'azéotrope est condensé, une phase solvant organique est séparée et la phase séparée est recyclée pour un nettoyage ultérieur d'un article sale.

**3.** Procédé selon les revendications 1 ou 2, dans lequel l'azéotrope est évaporé dans un récipient, lequel récipient contient le milieu aqueux à sa base et comporte un système de chauffage pour chauffer le milieu aqueux, et un orifice de sortie pour évaporer l'azéotrope, et un condenseur à travers l'orifice de sortie sur lequel l'azéotrope est condensé.

**4.** Procédé selon l'une quelconque des revendications précédentes, effectué dans un appareil à étages multiples, l'appareil comprenant une cuve pour l'immersion de l'article sale dans la composition de solvant et une cuve dans laquelle l'azéotrope est évaporé, et comportant des moyens pour condenser l'azéotrope, séparer le solvant du

milieu aqueux et recycler le solvant dans la cuve d'immersion.

**5.** Procédé selon l'une quelconque des revendications précédentes, dans lequel la formation d'azéotrope est effectuée à une température d'environ 60 à 100 °C.

**6.** Procédé selon l'une quelconque des revendications précédentes, dans lequel le milieu aqueux a une température d'au moins 98 °C.

**7.** Procédé selon l'une quelconque des revendications précédentes, dans lequel le milieu aqueux est de la vapeur.

**8.** Procédé selon la revendication 7, dans lequel la vapeur comprend de la vapeur d'eau et une pulvérisation d'eau à une température d'au moins environ 98 °C.

**9.** Procédé selon l'une quelconque des revendications précédentes, dans lequel l'évaporation azéotropique du résidu de solvant est effectuée alors que l'article est exposé à une atmosphère gazeuse.

**10.** Procédé selon l'une quelconque des revendications précédentes, dans lequel l'hydrocarbure aromatique est le para-cymène, le méta-cymène, un triméthyl-benzène ou un éthyltoluène.

**11.** Procédé selon l'une quelconque des revendications précédentes, dans lequel le constituant polaire organique est le 1-octanol, le 2-octanol ou le 2-éthylhexanol.

**12.** Composition de solvant, constituée uniquement :

d'au moins un hydrocarbure aromatique en $C_9$ à $C_{12}$ répondant à la formule

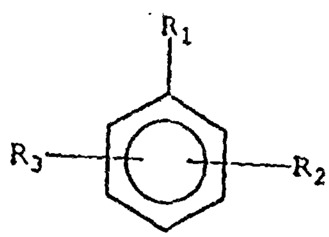

dans laquelle $R_1$ est $CH_3$, $R_2$ est un atome d'hydrogène ou un groupe alkyle inférieur à chaîne linéaire ou ramifiée, et $R_3$ est un atome d'hydrogène ou un groupe alkyle à chaîne linéaire en $C_1$ à $C_5$ ; et un constituant polaire organique en $C_7$ à $C_{10}$, la composition de solvant comprenant d'environ 1 à environ 99 % en poids du constituant polaire organique ; et la composition de solvant distillant dans un intervalle très étroit, ou formant un azéotrope bouillant à une température unique.

**13.** Composition de solvant constituée uniquement :

d'au moins un hydrocarbure aromatique en $C_9$ à $C_{12}$ répondant à la formule

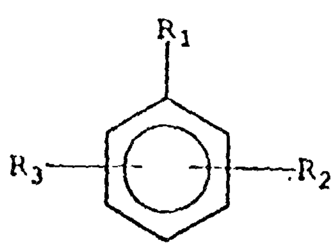

dans laquelle $R_1$ est $CH_3$, $R_2$ est un atome d'hydrogène ou un groupe alkyle inférieur à chaîne linéaire ou ramifiée, et $R_3$ est un atome d'hydrogène ou un groupe alkyle à chaîne linéaire en $C_1$ à $C_5$ ;
d'un constituant polaire organique en $C_7$ à $C_{10}$ ;
d'une proportion d'eau suffisante pour former une émulsion eau-dans-huile ; et
si on le désire d'un agent tensio-actif pour aider à former cette émulsion eau-dans-huile ; la composition de solvant comprenant d'environ 1 à environ 99 % en poids du constituant polaire organique ; et la composition de solvant distillant dans un intervalle très étroit, ou formant un azéotrope bouillant à une température unique.

**14.** Composition selon la revendication 12 ou la revendication 13, dans laquelle l'hydrocarbure aromatique est le para-cymène, le méta-cymène, un triméthylbenzène ou un éthyltoluène.

**15.** Composition selon la revendication 14, dans laquelle l'hydrocarbure aromatique est le para-cymène.

**16.** Composition selon l'une quelconque des revendications 12 à 15, dans laquelle le constituant polaire organique est un alcool, un ester, une amine ou une cétone.

**17.** Composition selon la revendication 16, dans laquelle le constituant polaire organique est le 1-octanol, le 2-octanol ou le 2-éthylhexanol.

**18.** Composition selon la revendication 17, dans laquelle le constituant polaire organique est le 2-éthyl-hexanol.

**19.** Composition selon l'une quelconque des revendications 12 à 18, comprenant d'environ 95 à environ 5 % en poids de l'hydrocarbure aromatique et d'environ 5 à environ 95 % en poids du constituant polaire organique.

**20.** Composition selon la revendication 19, comprenant environ 75 % en poids de l'hydrocarbure aromatique et environ 25 % en poids du constituant polaire organique.

**21.** Utilisation d'une composition selon l'une quelconque des revendications 12 à 20, dans un procédé de nettoyage d'un article sale selon l'une quelconque des revendications 1 à 11.

**Revendications pour l'Etat contractant suivant : ES**

**1.** Procédé de nettoyage d'un article sale, le procédé comprenant les étapes consistant à :

- mettre en contact l'article sale avec une composition de solvant comprenant :

  un hydrocarbure aromatique en $C_9$ à $C_{12}$ répondant à la formule

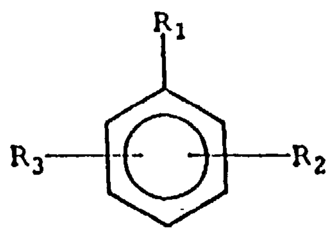

  dans laquelle $R_1$ est $CH_3$, $R_2$ est un atome d'hydrogène ou un groupe alkyle inférieur à chaîne linéaire ou ramifiée et $R_3$ est un atome d'hydrogène ou un groupe alkyle à chaîne linéaire en $C_1$ à $C_5$ ; et
  un constituant polaire organique en $C_7$ à $C_{10}$,
  la composition de solvant comprenant d'environ 99 à environ 1 % en poids de l'hydrocarbure aromatique et d'environ 1 à environ 99 % en poids du constituant polaire organique ;
  grâce auquel le contact de l'article sale avec la composition de solvant conduit à un résidu de solvant qui est déposé sur une surface de l'article ; et

- mettre en contact l'article ayant le résidu de solvant sur sa surface avec un milieu aqueux tel que le résidu de solvant soit éliminé par entraînement par la vapeur, ou forme un azéotrope avec le milieu aqueux et que cet azéotrope soit éliminé de la surface de l'article par évaporation azéotropique ; la composition de solvant distillant dans un intervalle très étroit, ou formant un azéotrope bouillant à une température unique.

**2.** Procédé selon la revendication 1, dans lequel l'azéotrope est condensé, une phase solvant organique est séparée et la phase séparée est recyclée pour un nettoyage ultérieur d'un article sale.

**3.** Procédé selon les revendications 1 ou 2, dans lequel l'azéotrope est évaporé dans un récipient, lequel récipient contient le milieu aqueux à sa base et comporte un système de chauffage pour chauffer le milieu aqueux, et un orifice de sortie pour évaporer l'azéotrope, et un condenseur à travers l'orifice de sortie sur lequel l'azéotrope est condensé.

4. Procédé selon l'une quelconque des revendications précédentes, effectué dans un appareil à étages multiples, l'appareil comprenant une cuve pour l'immersion de l'article sale dans la composition de solvant et une cuve dans laquelle l'azéotrope est évaporé, et comportant des moyens pour condenser l'azéotrope, séparer le solvant du milieu aqueux et recycler le solvant dans la cuve d'immersion.

5. Procédé selon l'une quelconque des revendications précédentes, dans lequel la formation d'azéotrope est effectuée à une température d'environ 60 à 100 °C.

6. Procédé selon l'une quelconque des revendications précédentes, dans lequel le milieu aqueux a une température d'au moins 98 °C.

7. Procédé selon l'une quelconque des revendications précédentes, dans lequel le milieu aqueux est de la vapeur.

8. Procédé selon la revendication 7, dans lequel la vapeur comprend de la vapeur d'eau et une pulvérisation d'eau à une température d'au moins environ 98 °C.

9. Procédé selon l'une quelconque des revendications précédentes, dans lequel l'évaporation azéotropique du résidu de solvant est effectuée alors que l'article est exposé à une atmosphère gazeuse.

10. Procédé selon l'une quelconque des revendications précédentes, dans lequel l'hydrocarbure aromatique est le para-cymène, le méta-cymène, un triméthyl-benzène ou un éthyltoluène.

11. Procédé selon l'une quelconque des revendications précédentes, dans lequel le constituant polaire organique est le 1-octanol, le 2-octanol ou le 2-éthylhexanol.

12. Procédé pour préparer une composition de solvant qui distille dans un intervalle très étroit, ou forme un azéotrope bouillant à une température unique, ce procédé consistant à mélanger au moins un hydrocarbure aromatique en $C_9$ à $C_{12}$ répondant à la formule

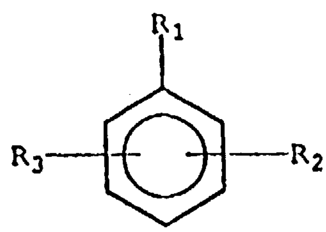

dans laquelle $R_1$ est $CH_3$, $R_2$ est un atome d'hydrogène ou un groupe alkyle inférieur à chaîne linéaire ou ramifiée, et $R_3$ est un atome d'hydrogène ou un groupe alkyle à chaîne linéaire en $C_1$ à $C_5$ ; et un constituant polaire organique en $C_7$ à $C_{10}$, la composition de solvant comprenant environ 1 à environ 99 % en poids du constituant polaire organique.

13. Procédé de préparation d'une composition de solvant qui distille dans un intervalle très étroit, ou forme un azéotrope bouillant à une température unique, ce procédé consistant à mélanger au moins un hydrocarbure aromatique en $C_9$ à $C_{12}$ répondant à la formule

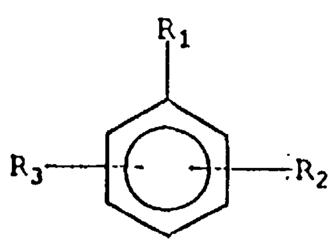

dans laquelle $R_1$ est $CH_3$, $R_2$ est un atome d'hydrogène ou un groupe alkyle inférieur à chaîne linéaire ou ramifiée, et $R_3$ est un atome d'hydrogène ou un groupe alkyle à chaîne linéaire en $C_1$ à $C_5$ ;

un constituant polaire organique en $C_7$ à $C_{10}$ ;
une proportion d'eau suffisante pour former une émulsion eau-dans-huile ; et
si on le désire, un agent tensio-actif pour aider à former cette émulsion eau-dans-huile ; la composition de

solvant comprenant d'environ 1 à environ 99 % en poids du constituant polaire organique.

**14.** Procédé selon la revendication 12 ou la revendication 13, dans lequel l'hydrocarbure aromatique est le para-cymène, le méta-cymène, un triméthylbenzène ou un éthyltoluène.

**15.** Procédé selon la revendication 14, dans lequel l'hydrocarbure aromatique est le para-cymène.

**16.** Procédé selon l'une quelconque des revendications 12 à 15, dans lequel le constituant polaire organique est un alcool, un ester, une amine ou une cétone.

**17.** Procédé selon la revendication 16, dans lequel le constituant polaire organique est le 1-octanol, le 2-octanol ou le 2-éthylhexanol.

**18.** Procédé selon la revendication 17, dans lequel le constituant polaire organique est le 2-éthyl-hexanol.

**19.** Procédé selon l'une quelconque des revendications 12 à 18, dans lequel la composition de solvant préparée comprend d'environ 95 à environ 5 % en poids de l'hydrocarbure aromatique et d'environ 5 à environ 95 % en poids du constituant polaire organique.

**20.** Procédé selon la revendication 19, dans lequel la composition de solvant préparée comprend environ 75 % en poids de l'hydrocarbure aromatique et environ 25 % en poids du constituant polaire organique.

**21.** Utilisation du produit d'un procédé selon l'une quelconque des revendications 12 à 20, dans un procédé de nettoyage d'un article sale selon l'une quelconque des revendications 1 à 11.

FIG.1

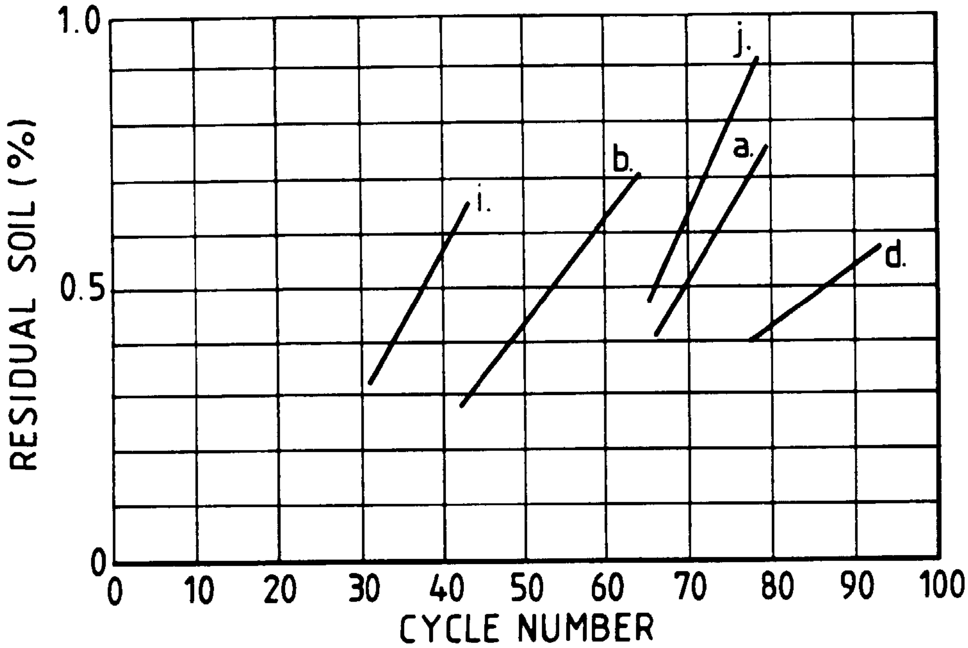
1.0
0.5
0
RESIDUAL SOIL (%)
0
10
20
30
40
50
60
70
80
90
100
CYCLE NUMBER
j.
a.
b.
i.
d.

FIG.2

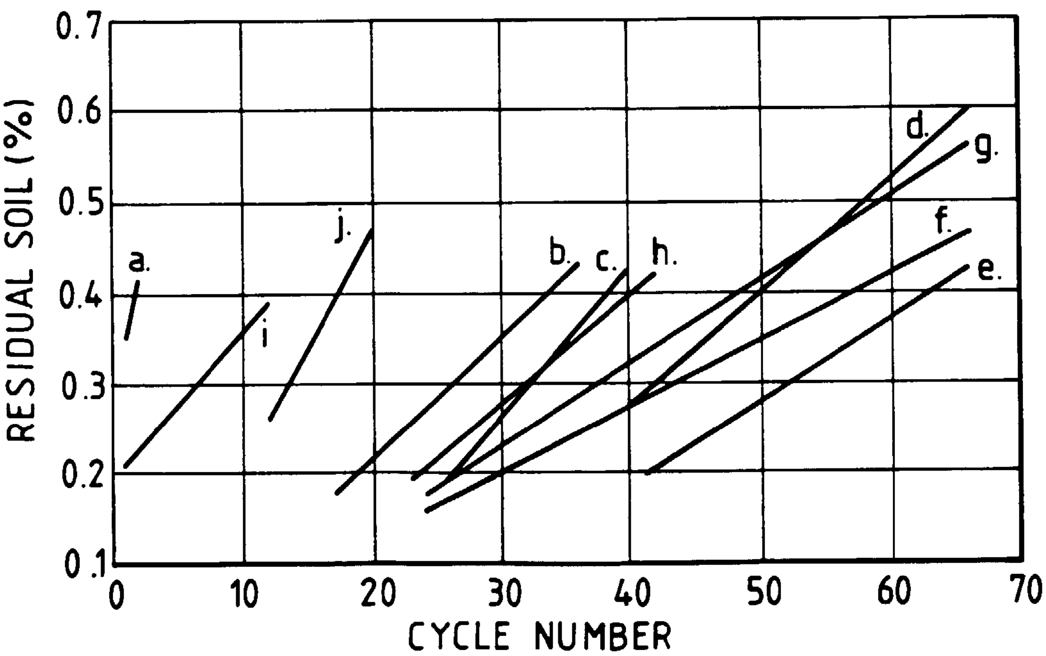
0.7
0.6
0.5
0.4
0.3
0.2
0.1
RESIDUAL SOIL (%)
0
10
20
30
40
50
60
70
CYCLE NUMBER
a.
i
j.
b.
c.
h.
d.
g.
f.
e.

FIG. 3

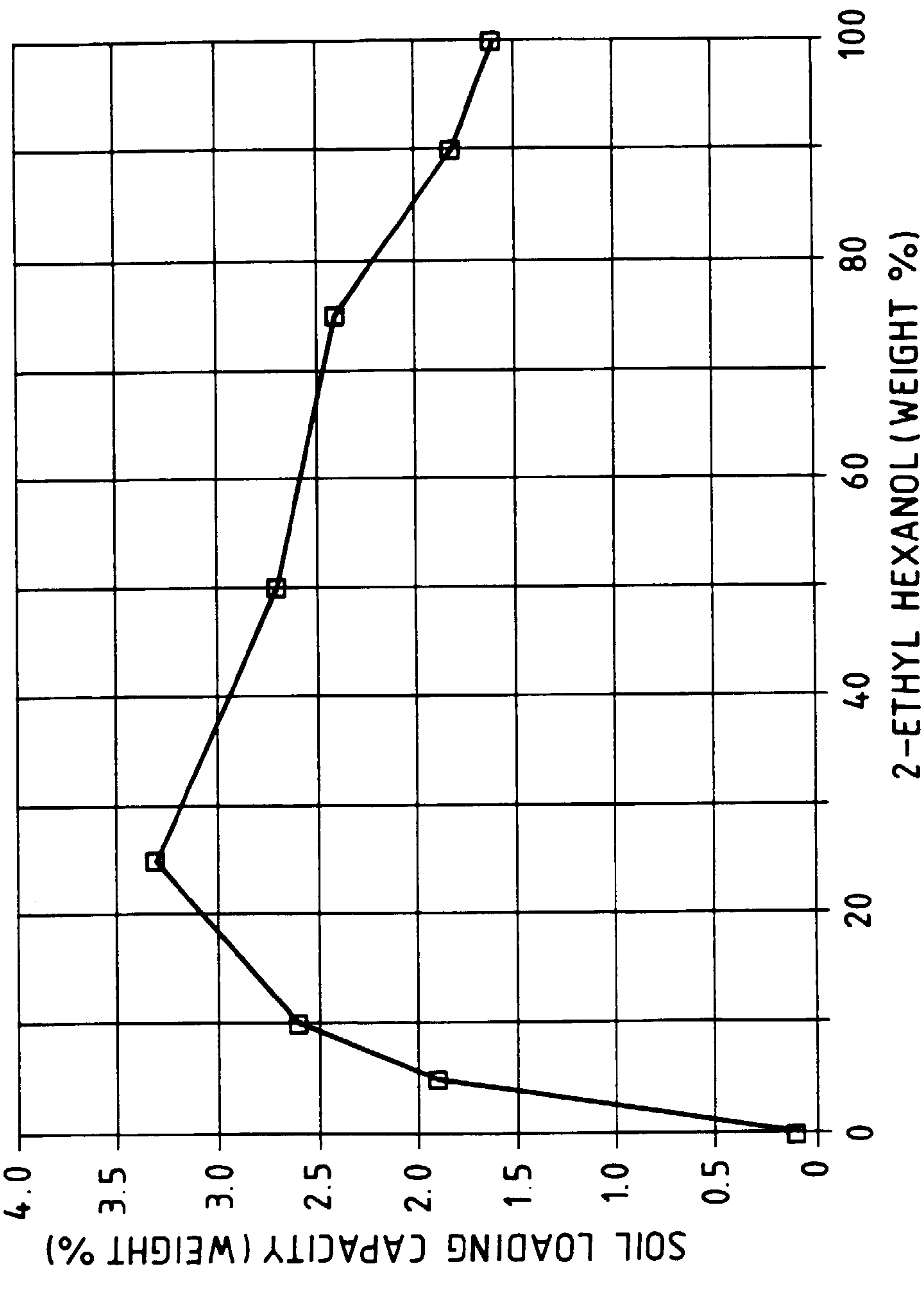
SOIL LOADING CAPACITY (WEIGHT %)
4.0
3.5
3.0
2.5
2.0
1.5
1.0
0.5
0
2-ETHYL HEXANOL (WEIGHT %)
0
20
40
60
80
100

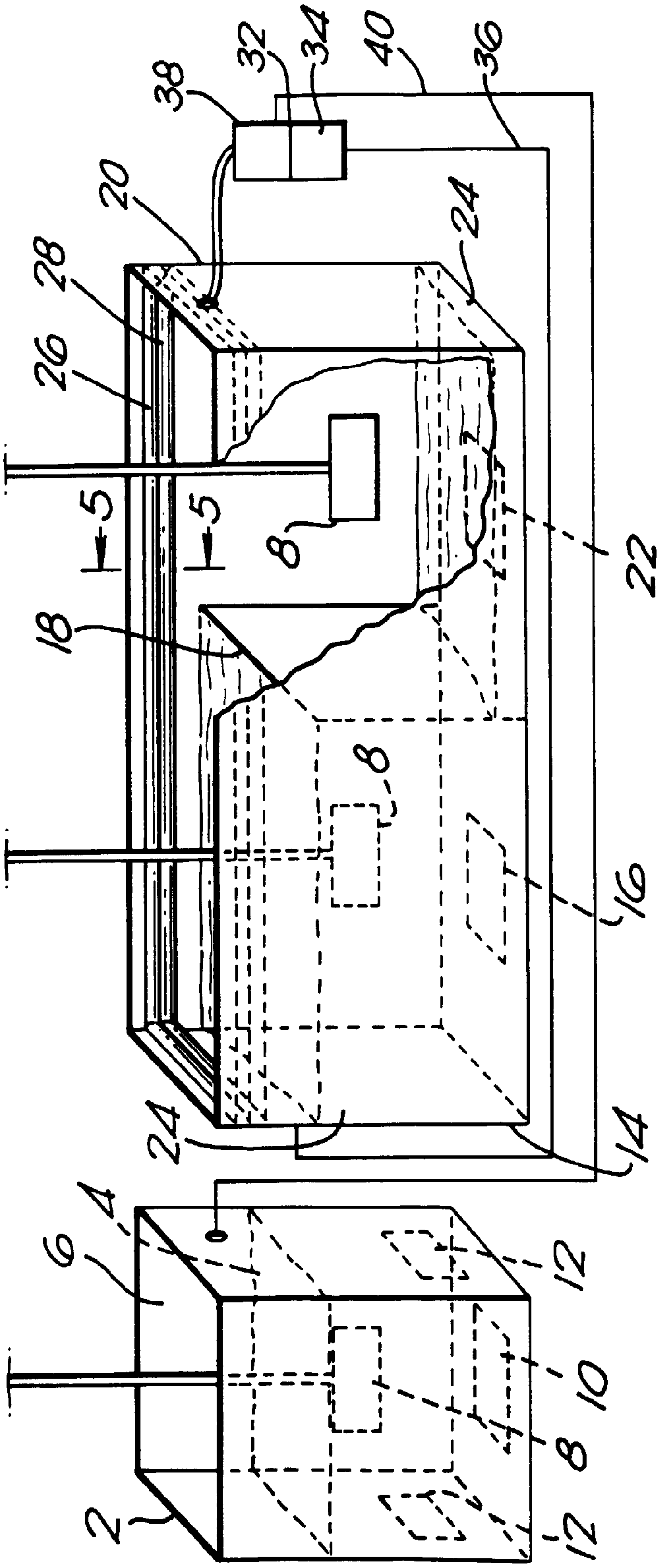
2
4
6
8
10
12
12
14
16
18
20
22
24
24
26
28
32
34
36
38
40
8
8
5
5

FIG. 4

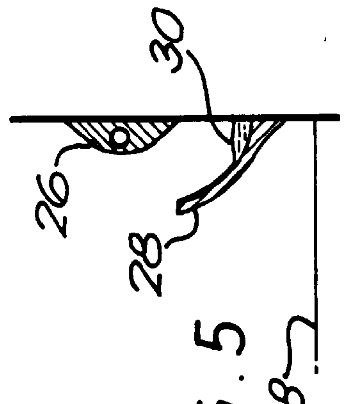
26
28
30
18

FIG. 5

FIG. 6